# FASCICULE DE BREVET EUROPEEN

(11) **EP 0 977 275 B1**
(45) Date de publication et mention de la délivrance du brevet: **07.03.2007**
(21) Numéro de dépôt: 99401897.6
(22) Date de dépôt: 26.07.1999
(51) Int. Cl.: H01L 31/105, H01L 27/146, G01J 5/20

(54) **Dispositif de détection de rayonnements multispectraux infrarouge/visible**
Infrarot/sichtbar multispektraler Strahlungsdetektor
Infrared/visible multispectral radiation detector

(30) Priorité: 28.07.1998 FR 9809645
(43) Date de publication de la demande: 02.02.2000
(73) Titulaire: COMMISSARIAT A L'ENERGIE ATOMIQUE, 75015 Paris (FR)
(72) Inventeur: Ouvrier-Buffet, Jean Louis, 74320 Sevrier (FR); Beccia, Chantal, Les Ruires, 38320 Eybens (FR); Vilain, Michel, 38450 Saint Georges de Commiers (FR)
(74) Mandataire: Poulin, Gérard

(56) Documents cités:
- EP-A- 0 354 369
- EP-A- 1 005 704
- WO-A-97/18589
- FR-A- 2 752 299
- US-A- 4 651 001
- US-A- 5 286 976
- US-A- 5 288 649
- PATENT ABSTRACTS OF JAPAN vol. 010, no. 302 (E-445), 15 octobre 1986 (1986-10-15) & JP 61 115355 A (TOSHIBA CORP), 2 juin 1986 (1986-06-02)

## Description

### Domaine de l'invention

L'invention concerne un dispositif pour détecter des rayonnements multispectraux infrarouge/visible avec une cohérence spatiale, ou même spatiotemporelle dans certains modes de réalisation.

Elle trouve des applications dans le domaine de la reconnaissance d'objets ou de personnes et dans le domaine de la surveillance.

### Etat de la technique

Dans les domaines de la reconnaissance et de la surveillance, de nombreuses sortes de détecteurs peuvent être utilisées en fonction du type de rayonnement à détecter.

En particulier, pour la détection des rayonnements visibles, il est classique d'utiliser des détecteurs photoélectriques réalisés à partir de matériaux semi-conducteurs dont les propriétés photoélectriques permettent de convertir les rayonnements visibles en signaux électriques. En effet, l'éclairement par un rayonnement visible génère, au sein des matériaux semi-conducteurs, un nombre de porteurs proportionnel à l'énergie lumineuse absorbée. Les détecteurs visibles les plus courants sont de type photovoltaïque, et sont, par exemple, des photodiodes pn, pin, à avalanche ou SCHOTTKY ou encore des phototransistors. Les charges électriques issues de ces détecteurs sont ensuite collectées, stockées et traitées par des dispositifs de multiplexage, ou dispositifs de lecture, de type CCD ou CMOS.

Par ailleurs, pour la détection de rayonnements infrarouge (IR), il est classique, pour l'homme de l'art, d'utiliser des détecteurs thermiques non refroidis. Ces détecteurs comportent, généralement, un ou plusieurs éléments sensibles pouvant être chauffés par un rayonnement infrarouge dans la bande III (8 à 12 µm), caractéristique de la température et de l'émissivité des corps observés. En effet, l'augmentation de température d'un élément sensible engendre une variation d'une des propriétés électriques du matériau sensible : apparition de charges électriques par effet pyroélectrique ou variation de la capacité par changement de la constante diélectrique ou bien variation de la résistance d'un matériau semi-conducteur ou métallique.

Toutefois, pour que ces détecteurs soient performants, il est nécessaire que le matériau sensible ait :
- une masse calorifique faible ;
- une bonne isolation thermique de la couche active vis-à-vis de son support, ce qui nécessite la réalisation d'un micropont ; et
- une forte sensibilité de l'effet de conversion de l'échauffement en signal électrique.

Seuls des détecteurs à couches minces répondent à ces conditions et, en particulier, les détecteurs thermiques bolométriques, tels que ceux décrits dans la demande de brevet FR-A-2 752 299 et dans la demande de brevet déposée sous le numéro 97 16791. Les détecteurs bolométriques de type métallique sont généralement réalisés en nickel (Ni), en titane (Ti), en nitrure de titane (TiN), ou encore en platine (Pt).

De tels détecteurs peuvent être connectés, en matrice, à un circuit de multiplexage en silicium de type CMOS ou CCD (appelé aussi circuit de lecture) pour réaliser des imageurs infrarouges monolithiques, fonctionnant à température ambiante.

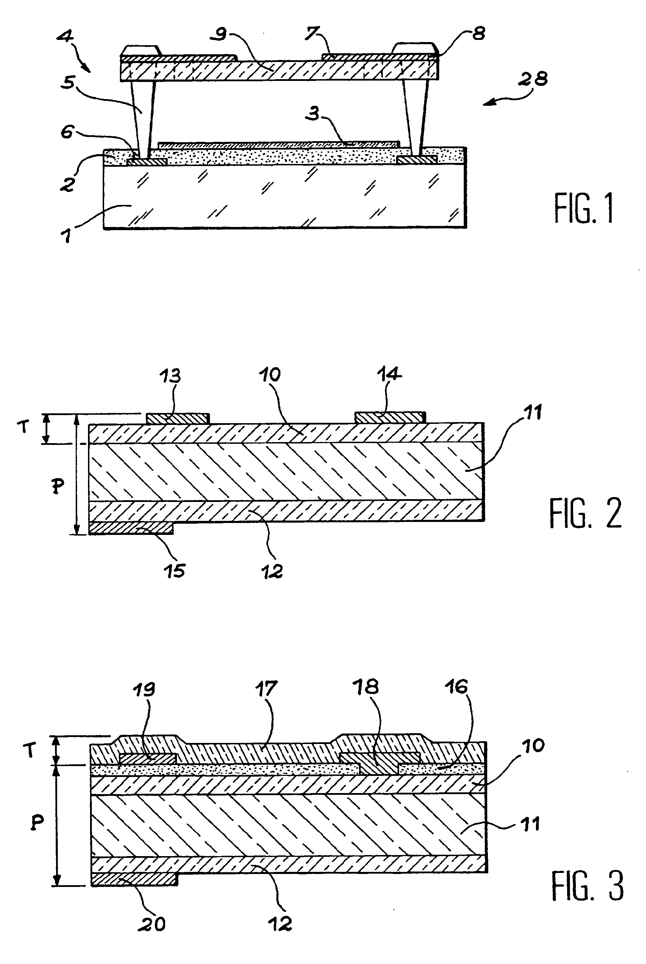

Un exemple de détecteur bolométrique à micropont (référencé 28), sur circuit de multiplexage, est représenté sur la figure 1. Le circuit de multiplexage du type CMOS ou CCD porte la référence 1 et le micropont la référence 4. Ce micropont 4 comprend des supports 5 assurant le support des éléments actifs du micropont et la connectique de ces éléments actifs avec le circuit de multiplexage 1 par l'intermédiaire de connexions en métal 6, incorporées dans une couche de matériau isolant 2 recouvrant le circuit de multiplexage 1. Les éléments actifs du micropont 4 sont : une couche de matériau sensible aux rayonnements IR, référencée 9, et des électrodes 7 prolongées par des bras d'isolement thermique 8. Un réflecteur 3 est placé sous le micropont pour assurer la réflexion des rayonnements IR vers le matériau sensible 9.

Le document US 4,621,001 décrit un dispositif de détection de rayonnements infrarouge et visible dans lequel les détecteurs sont placés l'un au-dessus de l'autre. Le document US 6,097,031 décrit un dispositif avec deux détecteurs séparés par une cavité.

Par ailleurs, pour la détection de rayonnements multispectraux, il existe des dispositifs de détection associés sous forme de barrettes ou de mosaïques. Dans ces dispositifs, des détecteurs d'un premier type de rayonnements sont associés avec des détecteurs d'un second type de rayonnements : ils sont soit juxtaposés ou adjacents les uns aux autres dans un même plan ou dans des plans différents, soit superposés strictement les uns sur les autres.

Les systèmes multispectraux superposés les plus courants, dans le domaine de la détection infrarouge, sont réalisés à partir d'un empilement de couches épitaxiales de CdₓHg₁₋ₓTe de compositions différentes, elles-mêmes épitaxiées sur un substrat transparent aux rayonnements infrarouges. Les bandes spectrales d'absorption sont déterminées par la composition x des couches détectrices. Ces détecteurs sont de type photovoltaïque et fonctionnent à basse température, dans une plage de longueurs d'ondes comprises entre 1 et 12 µm, c'est-à-dire en dehors du spectre du rayonnement visible.

Ces systèmes ne permettent donc pas la détection simultanée des rayonnements IR et visibles.

Dans le domaine des rayonnements infrarouges/visibles, les systèmes de détection multispectraux les plus courants sont réalisés à partir de deux caméras qui explorent les bandes spectrales, respectivement, de l'infrarouge et du visible, comme décrit dans l'article « IR/VIS Light Surveillance System Finds - Applications in Defense, Security », EUROPHOTONICS, Dec./Jan. 98. Dans un tel système, la caméra infrarouge (IR) est constituée de détecteurs refroidis, réalisés en InSb ou en CdₓHg₁₋ₓTe et fonctionnant dans les bandes II et III. La caméra visible est réalisée, par exemple, à partir d'un composant de type CCD.

D'autres systèmes de détection multispectraux consistent en une juxtaposition de détecteurs IR (infrarouge) refroidis en CdₓHg₁₋ₓTe et de détecteurs VIS (visible) en silicium. Le rayonnement provenant de la scène observée est alors scindé, par un dispositif extérieur, en deux faisceaux, qui sont ensuite focalisés sur chaque type de détecteurs.

Dans un tel système, les détecteurs visibles fonctionnent à température ambiante et les détecteurs infrarouges fonctionnent en froid. Ces systèmes présentent donc des coûts élevés et une mise en oeuvre complexe.

### Exposé de l'invention

L'invention a justement pour but de remédier aux inconvénients des techniques décrites précédemment.

A cette fin, elle propose un dispositif de détection multispectral infrarouge/visible utilisant des détecteurs photoélectrique et thermique simples, non-refroidis, placés approximativement l'un au-dessus de l'autre et pouvant avoir une (ou plusieurs) électrode(s) et/ou une couche active commune, ce qui assure une cohérence spatiale (voire spatiotemporelle dans certains cas) de la détection et évite un refroidissement de détecteur complexe et de coût élevé.

De façon plus précise, l'invention concerne un dispositif de détection de rayonnements multispectraux infrarouge/visible comportant :
- au moins un détecteur bolométrique comportant au moins une couche active et deux électrodes de commande et assurant la détection des rayonnements IR et visibles ; et
- au moins un détecteur photoélectrique comportant au moins deux couches actives et deux électrodes de commande et assurant uniquement la détection des rayonnements visibles. Un traitemement électronique des résultats des deux détections permet alors d'accéder à la composante infrarouge des rayonnements incidents.

Le détecteur bolométrique et le détecteur photoélectrique se caractérisent par le fait qu'ils sont de type non-refroidi et qu'ils sont placés en contact direct l'un au-dessus de l'autre et combinés l'un avec l'autre pour constituer un même élément sensible.

Dans le dispositif de l'invention, l'élément sensible comporte un micropont connecté à un circuit de multiplexage par l'intermédiaire de moyens de support et de connexion.

Selon un premier mode de réalisation, le micropont comporte les couches actives du détecteur bolométrique et du détecteur photoélectrique ainsi que leurs électrodes de commande.

Dans ce mode de réalisation, le détecteur bolométrique et le détecteur photoélectrique peuvent avoir au moins une électrode de commande commune.

Selon une variante de l'invention, les couches actives du détecteur photoélectrique forment une photodiode ayant une électrode inférieure et une électrode supérieure, cette dernière constituant également une des électrodes du détecteur bolométrique. Dans ce cas, le dispositif comporte une couche de a-Si:H de type P⁺ commune aux deux détecteurs, le détecteur photoélectrique comportant, en outre, une couche de a-Si:H intrinsèque et une couche de a-Si:H de type N⁺.

Selon une autre variante de l'invention, les couches actives du détecteur photoélectrique forment une photodiode isolée. Dans ce cas, la couche active du détecteur bolométrique est en a-Si:H de type P⁺/N⁺ ou en VOx/métal et les couches actives du détecteur photoélectrique sont en a-Si:H de type P⁺, a-Si:H intrinsèque et a-Si:H de type N⁺.

Selon encore une autre variante, les couches actives du détecteur photoélectrique forment un phototransistor. Dans ce cas, les couches actives du détecteur photoélectrique et du détecteur bolométrique sont en a-Si:H, à des dopages différents.

Selon un autre mode de réalisation de l'invention, le micropont comporte les couches actives et les électrodes de commande du détecteur bolométrique et le détecteur photoélectrique est placé sous le micropont, en regard du détecteur bolométrique.

Dans ce mode de réalisation, une partie au moins du micropont est réalisée dans des matériaux transparents aux rayonnements visibles ou bien comporte un ou plusieurs trous assurant le passage des rayonnements visibles à travers le micropont.

Le dispositif de l'invention peut, dans ce mode de réalisation, comporter un réflecteur placé sous le micropont, au-dessus du circuit d'adressage, et réalisé dans un matériau réfléchissant les rayonnements infrarouges et transparents aux rayonnements visibles.

Dans ce mode de réalisation, le détecteur photoélectrique peut être intégré au circuit de multiplexage.

Selon encore un autre mode de réalisation, le micropont comporte les couches actives et les électrodes du détecteur bolométrique qui forme, sur le circuit de multiplexage, des zones de réticulation dans lesquelles est inséré le détecteur photoélectrique.

Quel que soit le mode de réalisation, le dispositif peut comporter une pluralité d'éléments sensibles identiques, accolés les uns aux autres pour former une matrice d'éléments sensibles.

### Brève description des figures

- La figure 1, déjà décrite, représente un détecteur bolométrique à micropont, classique ;
- la figure 2 représente la partie active du micropont du dispositif de l'invention, conformément à un premier mode de réalisation ;
- la figure 3 représente la partie active du micropont du dispositif de l'invention, conformément à un second mode de réalisation ;
- la figure 4 représente la partie active du micropont du dispositif de l'invention, conformément à un troisième mode de réalisation ;
- la figure 5 représente un détecteur multispectral IR/VIS de l'invention, conforme à un quatrième mode de réalisation ; et
- la figure 6 représente une matrice de deux détecteurs multispectraux IR/VIS de l'invention, conformes à un cinquième mode de réalisation.

### Description détaillée de modes de réalisation de l'invention

L'invention concerne un dispositif de détection de rayonnements multispectraux infrarouge/visible utilisant un détecteur photoélectrique et un détecteur bolométrique associés l'un au-dessus de l'autre, tous deux de type non-refroidi. Ce dispositif peut être réalisé selon plusieurs modes de réalisation.

Un premier mode de réalisation de ce dispositif est représenté sur la figure 2. Plus précisément, cette figure 2 représente la partie active du micropont du dispositif de l'invention, cette partie comportant à la fois les moyens nécessaires à la détection photoélectrique et les moyens nécessaires à la détection thermique. Cette partie active du micropont représentée sur la figure 2, remplace, par rapport au détecteur bolométrique classique de la figure 1, les éléments 7 et 9 de la figure 1.

Cette partie active comporte trois couches de matériaux sensibles :
- une couche 10 de a-Si:H, ou bien de a-SiC:H, de type P⁺ qui constitue à la fois la couche sensible du détecteur bolométrique et une des couches sensibles du détecteur photoélectrique ;
- une couche 11 en a-Si:H ou a-SiGe:H, qui constitue la couche intrinsèque du détecteur photoélectrique ; et
- une couche 12 de a-Si:H, ou bien de a-SiC:H, de type N⁺ qui constitue la troisième couche du détecteur photoélectrique.

Les trois couches de matériaux sensibles 10, 11 et 12 sont toutes trois utilisées pour la détection photoélectrique, tandis que seule la couche 10 est utilisée pour la détection thermique.

Les références 13, 14 et 15 représentent trois électrodes : les électrodes supérieures 13 et 14 appartiennent à la partie de détection thermique, notée T sur la figure 2 et l'électrode 15 est l'une des électrodes du détecteur photoélectrique noté P.

En effet, pendant une première phase, le détecteur IR/VIS fonctionne en bolomètre. Ainsi, seules les électrodes supérieures 13 et 14 sont polarisées, tandis que l'électrode inférieure 15 n'est pas connectée. Comme les matériaux fortement dopés des couches 10 et 12 présentent peu, ou pas d'effet photoconducteur sous éclairement visible, la mesure de la résistance constituée par l'ensemble des trois couches révèle l'échauffement du micropont et mesure le rayonnement incident total (IR + visible).

Pendant une deuxième phase de mesure, le détecteur IR/vis fonctionne en détecteur photoélectrique. Les électrodes supérieures 13 et 14 sont court-circuitées et peuvent constituer une masse. Les couches 10, 11, 12 constituent alors une photodiode P⁺IN⁺ polarisée, avec les électrodes 13 et 14 à la masse et l'électrode 15 comme électrode de commande. Cette photodiode assure la détection du rayonnement visible. Par exemple, la mesure de la tension de circuit ouvert donne l'image du flux de photons et n'engendre pas d'échauffement du dispositif, à travers les résistances d'accès.

A titre d'exemple, on peut indiquer que les couches 10 et 12 ont une épaisseur comprise entre 0,01 µm et 1 µm et que la couche intrinsèque 11 a une épaisseur comprise entre 0,05 µm et 0,5 µm.

Le dispositif de détection qui vient d'être décrit permet d'assurer une cohérence spatiale de la détection des rayonnements multispectraux.

Sur la figure 3, on a représenté un second mode de réalisation du dispositif de l'invention dans lequel la détection thermique et la détection photoélectrique se font dans le micropont.

Selon ce mode de réalisation, la partie active du micropont comporte trois couches d'éléments sensibles 10, 11 et 12 identiques à celles montrées sur la figure 2, ainsi qu'une couche d'isolant 16 et qu'une quatrième couche sensible 17 en a-Si:H, de type P⁺ ou N', ou bien en Vox ou en métal.

Dans ce mode de réalisation, la couche sensible 17 assure la détection thermique uniquement. Les couches 10, 11, 12, ainsi que la couche isolante 16 réalisent une photodiode isolée qui permet la détection photoélectrique. Cette couche de matériau isolant 16 assure ainsi la séparation entre la couche active de la partie de détection thermique, notée T sur la figure, et de la partie de détection photoélectrique, notée P. Dans ce mode de réalisation, le micropont comporte, en outre, trois électrodes 18, 19 et 20. L'électrode 19 est une électrode spécifique à la détection thermique, c'est-à-dire une électrode spécifique au bolomètre, et l'électrode 20 est une électrode spécifique à la photodiode réalisant le détecteur photoélectrique. L'électrode 18 est une électrode commune aux deux détecteurs ; elle est positionnée en partie sur la couche isolante 16, mais elle est aussi, en partie, en contact avec la couche sensible 10.

Le détecteur obtenu en utilisant une telle partie active dans le micropont a l'avantage de réaliser une cohérence spatio-temporelle de la détection des rayonnements multispectraux avec seulement trois plots d'interconnexion, c'est-à-dire trois électrodes, puisque l'électrode 18 est commune aux deux types de détection. Autrement dit, la détection des rayonnements multispectraux se fait simultanément pour les rayonnements visibles et pour les rayonnements infrarouges et dans le même élément sensible, c'est-à-dire dans le même espace.

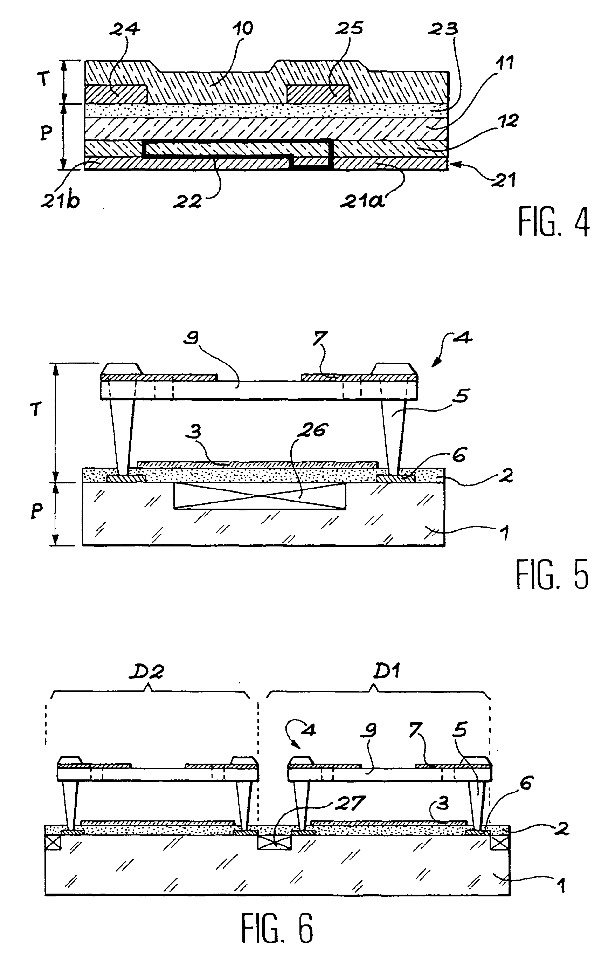

Sur la figure 4, on a représenté, schématiquement, la partie active du micropont conformément à un troisième mode de réalisation de l'invention. Selon ce mode de réalisation, le détecteur infrarouge/visible comporte une partie de détection thermique T constituée d'une couche sensible 10 et d'électrodes 24 et 25 et une partie de détection photoélectrique P.

La partie de détection photoélectrique P comporte, comme dans les modes de réalisation précédents, une couche 11 en a-Si:H et une couche active 12 en a-Si:H ou a-SiC:H de type N⁺. La partie de détection photoélectrique constitue, selon ce mode de réalisation, un phototransistor. Celui-ci comporte un isolant source/drain, référencé 22, et une couche de métal 21 réalisant, d'une part, la métallisation 21a du drain et, d'autre part, la métallisation 21b de la source, ce qui constitue deux des bornes du phototransistor. Le phototransistor comporte, de plus, une couche de matériau isolant 23 qui constitue l'isolant de la grille du phototransistor. La partie de détection thermique est placée au-dessus de cet isolant de grille 23. Elle comporte une couche 10, au sein de laquelle sont positionnées deux électrodes : une électrode 24 qui est l'une des électrodes du bolomètre et une électrode 25 qui constitue, d'une part, la seconde électrode du bolomètre et, d'autre part, la grille du phototransistor. Ainsi, comme dans le mode de réalisation de la figure 3, la partie de détection photoélectrique P et la partie de détection thermique T ont en commun une électrode, à savoir l'électrode 25.

Pendant la phase de détection thermique, seules les électrodes supérieures 24 et 25 sont polarisées. Avec la couche semi-conductrice 10, elles forment une résistance capable de mesurer la température de la « planche bolométrique ». Les métallisations source et drain (21b, 21a) ne sont pas connectées. Ainsi, la remarque faite précédemment en ce qui concerne la photoconductivité des matériaux fortement dopés demeure valable.

Durant la phase de détection photoélectrique, les électrodes supérieures 25 et 24 sont portées au même potentiel. L'électrode 25 sert de grille au phototransistor. Les métallisations des source et drain 21b, 21a sont alors connectées à leurs alimentations. Comme la circulation du courant à travers le transistor peut échauffer le dispositif, la détection thermique est effectuée après retour à l'équilibre thermique de ce dernier.

En connectant le drain du phototransistor à l'électrode 25 de la résistance bolométrique qui constitue aussi la grille du phototransistor, le fonctionnement d'un tel détecteur visible/infrarouge ne demande que trois plots d'alimentation 24, 25 et 22.

Sur les figures 5 et 6, on a représenté deux autres modes de réalisation de l'invention, dans lesquels la partie de détection thermique T est placée dans le micropont du détecteur et la partie de détection photoélectrique P est placée sur le circuit de multiplexage.

La figure 5 montre donc un quatrième mode de réalisation de l'invention, dans lequel la partie de détection thermique T est placée dans le micropont 4 et la partie de détection photoélectrique P est placée sur le circuit de multiplexage 1, sous le micropont. Autrement dit, dans ce mode de réalisation, la détection thermique s'effectue au niveau du micropont 4, de façon classique, par contre, la détection photoélectrique s'opère au niveau du circuit de multiplexage, ou circuit de lecture CMOS ou CCD, par l'intermédiaire d'une photodiode ou d'un phototransistor, référencé 26, situé sous le micropont. En d'autres termes, on retrouve sur cette figure 5 le même micropont 4 que sur la figure 1 avec ses supports 5, ses zones de contact 6, ses électrodes 7 et sa couche sensible 9. Ce micropont 4 est connecté au circuit de multiplexage 1 recouvert d'une couche isolante 2. Un réflecteur 3 assure la réflexion des rayonnements infrarouges vers la couche sensible 9.

Par ailleurs, ce détecteur infrarouge/visible de l'invention comporte une photodiode ou un phototransistor, référencé 26 sur la figure 5, qui assure la détection photoélectrique. Aussi, afin que cette photodiode ou ce phototransistor 26 puisse capter les rayonnements visibles, le micropont est, au moins en partie, transparent aux rayonnements visibles, ce qui signifie que la couche sensible 9 et les électrodes 7 sont transparents aux rayonnements visibles. Pour cela, cette couche sensible 9 et/ou les électrodes 7 peuvent comporter un ou plusieurs trous laissant passer les rayonnements visibles. Cette variante convient essentiellement lorsque le micropont est réalisé dans des matériaux absorbants de par leur nature, ou leur épaisseur. Aussi, les trous réalisés dans le micropont peuvent ne concerner que les couches effectivement absorbantes. Selon une autre variante, le micropont peut être réalisé dans un matériau transparent, ou bien réalisé dans un matériau d'épaisseur très mince de façon à être transparent et faiblement absorbant.

Dans ce mode de réalisation, le réflecteur 3 est réalisé dans un matériau qui assure, d'une part, la réflexion des rayonnements infrarouges vers la couche sensible 9 et qui assure, d'autre part, la transparence pour les rayonnements visibles devant atteindre la photodiode ou le phototransistor 26. Ce réflecteur 3 peut être réalisé à partir d'oxydes transparents conducteurs, comme du ZnO, SnO₂, ITO (Indium Tin Oxide) ; il peut alors être optimisé, d'une part, de façon à réfléchir le maximum de rayonnements infrarouges dans la bande 8 - 12 µm (pouvoir réflecteur supérieur à 90 %) et, d'autre part, de façon à présenter le maximum de transparence aux rayonnements visibles.

De même que pour le micropont, le réflecteur 3 peut aussi être rendu transparent aux rayonnements visibles par l'intermédiaire de trous.

Sur la figure 6, on a représenté le cinquième mode de réalisation de l'invention dans lequel la partie de détection thermique est située dans le micropont et la partie de détection photoélectrique est située sur le circuit de multiplexage, en bordure du micropont.

Sur cette figure 6, on a représenté un circuit de multiplexage 1 sur lequel sont connectés deux détecteurs D1 et D2 conformes à l'invention.

Seul le détecteur visible/infrarouge D2 va maintenant être décrit, le détecteur D1 étant strictement identique au détecteur D2.

Comme on le voit sur cette figure 6, la partie de détection thermique est identique à un détecteur bolométrique classique, tel que représenté sur la figure 1, en ce qui concerne le micropont 4, la connexion 5, 6 du micropont sur le circuit de multiplexage 1 et le réflecteur 3. Par contre, le détecteur infrarouge/visible de l'invention comporte une partie de détection photoélectrique 27 qui peut être une photodiode ou un phototransistor, positionnée dans la place dégagée par la réticulation de la partie de détection thermique, c'est-à-dire du détecteur bolométrique, sur le circuit de multiplexage 1. La partie de détection photoélectrique 27 étant dans la réticulation de la partie de détection thermique, ces deux parties de détection sont situées dans un même élément sensible ; autrement dit, cet ensemble constitue un même point élémentaire, bien que la partie de détection photoélectrique soit décalée de quelques dixièmes de microns par rapport à la partie de détection thermique. La détection des deux spectres se faisant dans un même point élémentaire, on considère que la détection se fait avec une cohérence spatiale.

Le mode de réalisation, montré sur la figure 6, a l'avantage d'être facile à réaliser puisque le détecteur photoélectrique n'est pas placé strictement à l'intérieur du détecteur thermique.

Quel que soit le mode de réalisation de l'invention, plusieurs détecteurs infrarouges/visibles peuvent être associés et placés sur un même circuit de multiplexage (comme montré sur la figure 6 avec les deux détecteurs D1 et D2), réalisant ainsi une matrice d'éléments sensibles. Une telle architecture matricielle a de nombreuses applications et, en particulier, peut être utilisée dans l'imagerie infrarouge et visible.

L'utilisation de microstructures en couches minces, telles que décrites à travers les différents modes de réalisation de l'invention, permet de réaliser une isolation thermique efficace de la matrice d'éléments sensibles par rapport au circuit de multiplexage. Ces microstructures peuvent être élaborées suivant différents procédés qui conduisent nécessairement à la fabrication de microponts :
- par sous-gravure du substrat de silicium sous les éléments sensibles, l'isolant ainsi partiellement du substrat ; ou
- à partir d'une couche sacrificielle, typiquement en polyimide, sur laquelle sont élaborés les éléments sensibles.

Ces méthodes de fabrication étant connues de l'homme de l'art et décrites, notamment, dans le document FR-A-2 752 299, elles ne seront pas décrites de façon plus précise dans cette demande.

Il est à noter toutefois que les couches minces des éléments (couches d'épaisseurs comprises entre 0,005 µm et 1 µm) en matériau isolant (SiN, SiO, ZnS, etc.) ou en semi-conducteur amorphe ou polycristallin (Si, Ge, SiC, a-Si:H, a-SiC:H, a-SiGe:H, etc.) sont obtenues à l'aide des techniques de dépôt basse température habituellement utilisées pour ces matériaux, à savoir la pulvérisation cathodique, la décomposition thermique ou la décomposition plasma. Le dopage éventuel de ces couches est réalisé en introduisant, dans le réacteur, un gaz dopant, tel que le BF3 ou le PH3 ou bien par implantation ionique. La gravure de ces matériaux est généralement réalisée par des procédés d'attaque chimique assistée par plasma.

Les matériaux métalliques (Ti, TiN, Pt, Al, Pd, Ni, NiCr, etc.) constituant les éléments résistifs, les électrodes et les diverses métallisations du détecteur de l'invention sont également déposés par pulvérisation cathodique ou par décomposition thermique ou plasma.

Dans un souci d'optimisation, la résistance équivalente par carré des couches constituant les électrodes sera adaptée à l'impédance du vide. D'autre part, la distance entre les électrodes et le réflecteur est également adaptée de manière à réaliser une cavité quart d'onde conduisant au maximum d'absorption, à la longueur d'onde recherchée.

Par ailleurs, le détecteur photoélectrique peut être adapté au domaine des longueurs d'onde recherchées : domaine visible, domaine UV, voire domaine des rayons X.

## Revendications

1. Dispositif de détection de rayonnements multispectraux infrarouge/visible comportant :
- au moins un détecteur bolométrique (I) comportant au moins une couche active (10) et deux électrodes de commande et assurant la détection des rayonnements IR et visibles ; et
- au moins un détecteur photoélectrique (V) comportant au moins deux couches actives (11, 12) et deux électrodes de commande et assurant uniquement la détection des rayonnements visibles,
le détecteur bolométrique et le détecteur photoélectrique sont placés en contact direct l'un au-dessus de l'autre et combinés l'un avec l'autre pour former un même élément sensible, **caractérisé en ce que** le détecteur bolométrique et le détecteur photoélectrique sont de type non-refroidi.

2. Dispositif selon la revendication 1 dans lequel l'élément sensible comporte un micropont (4) connecté à un circuit de multiplexage (1) par l'intermédiaire de moyens de support et de connexion (5, 6, 8), **caractérisé en ce que** le micropont comporte les couches actives du détecteur bolométrique et du détecteur photoélectrique (10, 11, 12) ainsi que leurs électrodes de commande (13, 14, 15).

3. Dispositif selon la revendication 2, **caractérisé en ce que** le détecteur bolométrique et le détecteur photoélectrique ont au moins une électrode de commande commune (14).

4. Dispositif selon la revendication 2 ou 3, **caractérisé en ce que** les couches actives (10, 11, 12) du détecteur photoélectrique forment une photodiode ayant une électrode inférieure (15) et une électrode supérieure (14), cette dernière constituant également une des électrodes du détecteur bolométrique.

5. Dispositif selon la revendication 4, **caractérisé en ce qu'**il comporte une couche de a-Si:H de type P⁺ commune aux deux détecteurs, le détecteur photoélectrique comportant, en outre, une couche de a-Si:H intrinsèque et une couche de a-Si:H de type N⁺.

6. Dispositif selon la revendication 3, **caractérisé en ce que** les couches actives (11, 12, 16) du détecteur photoélectrique forment une photodiode isolée.

7. Dispositif selon la revendication 6, **caractérisé en ce que** la couche active (10) du détecteur bolométrique est en a-Si:H de type P⁺ ou N⁺ ou en Vox ou en métal et les couches actives du détecteur photosensible sont en α-Si:H de type P⁺, a-Si:H intrinsèque et a-Si:H de type N⁺.

8. Dispositif selon la revendication 3, **caractérisé en ce que** les couches actives (11, 12, 23) du détecteur photoélectrique forment un phototransistor.

9. Dispositif selon la revendication 8, **caractérisé en ce que** les couches actives du détecteur photoélectrique et du détecteur bolométrique sont en a-Si:H, à des dopages différents.

10. Dispositif selon la revendication 1 dans lequel l'élément sensible comporte un micropont (4) connecté à un circuit de multiplexage (1) par l'intermédiaire de moyens de support et de connexion (5, 6, 8), **caractérisé en ce que** le micropont comporte la couche active (9) et les électrodes de commande (7) du détecteur bolométrique et **en ce que** le détecteur photoélectrique (26) est placé sous le micropont, en regard du détecteur bolométrique.

11. Dispositif selon la revendication 10, **caractérisé en ce que** une partie au moins du micropont est réalisée dans des matériaux transparents aux rayonnements visibles.

12. Dispositif selon la revendication 10, **caractérisé en ce que** la couche active et/ou les électrodes du détecteur bolométrique comportent un ou plusieurs trous assurant le passage des rayonnements visibles à travers le micropont.

13. Dispositif selon les revendications 10, 11 ou 12 dans lequel l'élément sensible comporte un réflecteur (3) placé sous le micropont, au-dessus du circuit d'adressage, **caractérisé en ce que** ledit réflecteur est réalisé dans un matériau réfléchissant les rayonnements infrarouges et transparent aux rayonnements visibles.

14. Dispositif selon l'une quelconque des revendications 10 à 13, **caractérisé en ce que** le détecteur photoélectrique est intégré au circuit de multiplexage.

15. Dispositif selon la revendication 1, dans lequel l'élément sensible comporte un micropont (4) connecté à un circuit de multiplexage (1) par l'intermédiaire de moyens de support et de connexion (5, 6, 8), **caractérisé en ce que** le micropont comporte la couche active (9) et les électrodes (7) du détecteur bolométrique qui forme, sur le circuit de multiplexage (1), des zones de réticulation dans lesquelles est inséré le détecteur photoélectrique (27).

16. Dispositif selon l'une quelconque des revendications 1 à 15, **caractérisé en ce qu'**il comporte une pluralité d'éléments sensibles identiques, accolés les uns aux autres pour former une matrice d'éléments sensibles.

## Claims

1. Device for the detection of multispectral infrared/visible radiation comprising:
- at least one bolometric detector (I) having at least one active layer (10) and two control electrodes and ensuring the detection of IR and visible radiation and
- at least one photoelectric detector (V) having at least two active layers (11, 12) and two control electrodes and solely ensuring the detection of visible radiation,
the bolometric detector and the photoelectric detector are superimposed and the photoelectric detector is of the uncooled type and that they are superimposed and combined with one another to form the same sensitive element, **characterized in that** the bolometric detector and the photoelectric detector are of the uncooled type.

2. Device according to claim 1, wherein the sensitive element comprises a microbridge (4) connected to a multiplexing circuit (1) by support and connection means (5, 6, 8), **characterized in that** the microbridge incorporates active layers of the bolometric detector and the photoelectric detector (10, 11, 12), as well as their control electrodes (13, 14, 15).

3. Device according to claim 2, **characterized in that** the bolometric detector and the photoelectric detector have at least one common control electrode (14).

4. Device according to claim 2, **characterized in that** the active layers (10, 11, 12) of the photoelectric detector form a photodiode having a lower electrode (15) and an upper electrode (14), the latter also constituting one of the electrodes of the bolometric detector.

5. Device according to claim 4, **characterized in that** it has a type P⁺ a-Si:H layer common to the two detectors, the photoelectric detector also having an intrinsic a-Si:H layer and a type N⁺ a-Si:H layer.

6. Device according to claim 3, **characterized in that** the active layers (11, 12, 16) of the photoelectric detector form an insulated photodiode.

7. Device according to claim 6, **characterized in that** the active layer (10) of the bolometric detector is of type P⁺ or N⁺ a-Si:H or Vox or metal and the active layers of the photosensitive detector are of type P⁺ a-Si:H, intrinsic a-Si:H and type N⁺ a-Si:H.

8. Device according to claim 3, **characterized in that** the active layers (11, 12, 23) of the photoelectric detector form a phototransistor.

9. Device according to claim 8, **characterized in that** the active layers of the photoelectric detector and the bolometric detector are of a-Si:H with different doping levels.

10. Device according to claim 1, in which the sensitive element incorporates a microbridge (4) connected to a multiplexing circuit (1) by support and connection means (5, 6, 8), **characterized in that** the microbridge incorporates the active layer (9) and the bolometric detector control electrode (7) and **in that** the photoelectric detector (26) is placed beneath the microbridge facing the bolometric detector.

11. Device according to claim 10, **characterized in that** at least part of the microbridge is made from materials transparent to visible radiation.

12. Device according to claim 10, **characterized in that** the active layer and/or electrodes of the bolometric detector have one or more holes ensuring the passage of visible radiation through the microbridge.

13. Device according to claims 10, 11 or 12, in which the sensitive element has a reflector (3) placed beneath the microbridge and above the addressing circuit, **characterized in that** said reflector is made from a material reflecting infrared radiation and transparent to visible radiation.

14. Device according to any one of the claims 10 to 13, **characterized in that** the photoelectric detector is integrated into the multiplexing circuit.

15. Device according to claim 1, in which the sensitive element incorporates a microbridge (4) connected to a multiplexing circuit (1) by support and connection means (5, 6, 8), **characterized in that** the microbridge incorporates the active layer (9) and the electrodes (7) of the bolometric detector which forms, on the multiplexing circuit (1), reticulation zones, in which is inserted the photoelectric detector (27).

16. Device according to any one of the claims 1 to 15, **characterized in that** it has a plurality of identical, sensitive elements, joined to one another in order to form an array of sensitive elements.

## Patentansprüche

1. Multispektrale Detektionsvorrichtung für IR- und sichtbare Strahlung, umfassend:
- mindestens einen bolometrischen Detektor (I) mit wenigstens einer aktiven Schicht (10) und zwei Steuerelektroden, der die Detektion von IR- und sichtbarer Strahlungen gewährleistet; und
- mindestens einen photoelektrischen Detektor (V) mit wenigstens zwei aktiven Schichten (11, 12) und zwei Steuerelektroden, der nur die Detektion von sichtbarer Strahlungen gewährleistet,
wobei der bolometrische Detektor und der photoelektrische Detektor mit direktem Kontakt aufeinander angeordnet und miteinander kombiniert bzw. gekoppelt sind, so dass sie ein einziges empfindliches Element bilden,
**dadurch gekennzeichnet, dass** der bolometrische Detektor und der photoelektrische Detektor vom nichtgekühlten Typ sind.

2. Vorrichtung nach Anspruch 1, bei der das empfindliche Element eine Mikrobrücke (4) umfasst, die durch Trag- und Verbindungseinrichtungen (5, 6, 8) mit eine Multiplexschaltung (1) verbunden ist, **dadurch gekennzeichnet, dass** die Mikrobrücke die aktiven Schichten des bolometrischen Detektors und des photoelektrischen Detektors (10, 11, 12) sowie ihre Steuerelektroden (13, 14, 15) umfasst.

3. Vorrichtung nach Anspruch 2, **dadurch gekennzeichnet, dass** der bolometrische Detektor und der photoelektrische Detektor wenigstens eine gemeinsame Steuerelektrode (14) haben.

4. Vorrichtung nach Anspruch 2 oder 3, **dadurch gekennzeichnet, dass** die aktiven Schichten (10, 11, 12) des photoelektrischen Detektors eine Photodiode mit einer unteren Elektrode (15) und einer oberen Elektrode (14) bilden, wobei diese letztere auch eine der Elektroden des bolometrischen Detektors bildet.

5. Vorrichtung nach Anspruch 4, **dadurch gekennzeichnet, dass** sie eine für beide Detektoren gemeinsame a-Si:H-Schicht des Typs P⁺ umfasst, wobei der photoelektrische Detektor außerdem eine intrinsische a-Si:H-Schicht und eine a-Si:H-Schicht des Typs N⁺ umfasst.

6. Vorrichtung nach Anspruch 3, **dadurch gekennzeichnet, dass** die aktiven Schichten (11, 12, 16) des photoelektrischen Detektors eine isolierte Photodiode bilden.

7. Vorrichtung nach Anspruch 6, **dadurch gekennzeichnet, dass** die aktive Schicht (10) des bolometrischen Detektors aus a-Si:H des Typs P⁺ oder N⁺ oder aus Vox oder aus Metall ist, und die aktiven Schichten des photosensiblen Detektors aus a-Si:H des Typs P⁺, intrinsischern a-Si:H und a-Si:H des Typs N⁺ sind.

8. Vorrichtung nach Anspruch 3, **dadurch gekennzeichnet, dass** die aktiven Schichten (11, 12, 23) des photoelektrischen Detektors einen Phototransistor bilden.

9. Vorrichtung nach Anspruch 8, **dadurch gekennzeichnet, dass** die aktiven Schichten des photoelektrischen Detektors und des bolometrischen Detektors aus a-Si:H sind, mit unterschiedlichen Dotierungen.

10. Vorrichtung nach Anspruch 1, bei der das empfindliche Element eine Mikrobrücke (4) umfasst, die durch Trag- und Verbindungseinrichtungen (5, 6, 8) mit eine Multiplexschaltung (1) verbunden ist, **dadurch gekennzeichnet, dass** die Mikrobrücke die aktive Schicht (9) und die Steuerelektroden (7) des bolometrischen Detektors umfasst, und **dadurch**, dass der photoelektrische Detektor (26) sich unter der Mikrobrücke befinden, dem bolometrischen Detektor gegenüber.

11. Vorrichtung nach Anspruch 10, **dadurch gekennzeichnet, dass** wenigstens ein Teil der Mikrobrücke aus einem für sichtbare Strahlungen transparenten Material ist.

12. Vorrichtung nach Anspruch 10, **dadurch gekennzeichnet, dass** die aktive Schicht und/oder die Elektroden des bolometrischen Detektors ein oder zwei Löcher umfassen, um die sichtbaren Strahlungen durch die Mikrobrücke hindurch durchzulassen.

13. Vorrichtung nach den Ansprüchen 10, 11 oder 12, bei der das empfindliche Element einen Reflektor (3) umfasst, angeordnet unter der Mikrobrücke, über der Adressierschaltung, **dadurch gekennzeichnet, dass** der genannte Reflektor aus einem die IR-Strahlungen reflektierenden und die sichtbare Strahlung durchlassenden Material ist.

14. Vorrichtung nach einem der Ansprüche 10 bis 13, **dadurch gekennzeichnet, dass** der photoelektrische Detektor in die Multiplexschaltung integriert ist.

15. Vorrichtung nach Anspruch 1, bei der das empfindliche Element eine Mikrobrücke (4) umfasst, die durch Trag- und Verbindungseinrichtungen (5, 6, 8) mit eine Multiplexschaltung (1) verbunden ist, **dadurch gekennzeichnet, dass** die Mikrobrücke die aktive Schicht (9) und die Steuerelektroden (7) des bolometrischen Detektors umfasst, der auf der Multiplexschaltung (1) Vernetzungszonen bildet, in die der photoelektrische Detektor (27) eingefügt ist.

16. Vorrichtung nach einem der Ansprüche 1 bis 15, **dadurch gekennzeichnet**, das sie eine Vielzahl identischer empfindlicher Elemente umfasst, die so miteinander verbunden sind, dass sie eine Matrix aus empfindlichen Elementen bilden.
